# EUROPEAN PATENT SPECIFICATION

(11) **EP 4 270 491 B1**
(45) Date of publication and mention of the grant of the patent: **02.12.2026**
(21) Application number: 22794337.0
(22) Date of filing: 03.03.2022
(51) Int. Cl.: H10D 8/00, H10D 8/01, H10D 62/10, H10D 64/00

(54) **DIODE AND MANUFACTURING METHOD THEREFOR, AND SEMICONDUCTOR DEVICE**
DIODE UND HERSTELLUNGSVERFAHREN DAFÜR SOWIE HALBLEITERBAUELEMENT
DIODE ET SON PROCÉDÉ DE FABRICATION, ET DISPOSITIF À SEMI-CONDUCTEURS

(30) Priority: 30.04.2021 CN 202110484015
(43) Date of publication of application: 01.11.2023
(73) Proprietor: CSMC Technologies Fab2 Co., Ltd., Wuxi New District Wuxi Jiangsu 214028 (CN)
(72) Inventor: GU, Yan, Wuxi, Jiangsu 214028 (CN); SONG, Hua, Wuxi, Jiangsu 214028 (CN); HE, Nailong, Wuxi, Jiangsu 214028 (CN); ZHANG, Sen, Wuxi, Jiangsu 214028 (CN)
(74) Representative: Michalski Hüttermann & Partner mbB
(86) International application number: PCT/CN2022/079011
(87) International publication number: WO 2022/227858

(56) References cited:
- CN-A- 102 376 773
- CN-A- 102 403 341
- CN-A- 105 990 423
- CN-A- 110 190 113
- CN-A- 111 933 687
- CN-A- 112 133 760
- US-A1- 2005 056 906
- US-A1- 2007 158 680
- US-A1- 2012 032 313
- US-A1- 2014 110 814
- US-A1- 2017 025 411
- AKIO NAKAGAWA ET AL: "BREAKDOWN VOLTAGE ENHANCEMENT FOR DEVICES ON THIN SILICON LAYER/ SILICON DIOXIDE FILM", IEEE TRANSACTIONS ON ELECTRON DEVICES, IEEE, USA, vol. 38, no. 7, 1 July 1991 (1991-07-01), pages 1650 - 1654, XP000206663, ISSN: 0018-9383, DOI: 10.1109/16.85162
- FUNAKI H ET AL: "LATERAL SOI DIODE DESIGN OPTIMIZATION FOR HIGH RUGGEDNESS AND LOW TEMPERATURE DEPENDENCE OF REVERSE RECOVERY CHARACTERISTICS", PROCEEDINGS OF THE 10TH INTERNATIONAL SYMPOSIUM ON POWER SEMICONDUCTOR DEVICES & IC'S. ISPSD '98. KYOTO, JUNE 3 - 6, 1998; [INTERNATIONAL SYMPOSIUM ON POWER SEMICONDUCTOR DEVICES & IC'S], NEW YORK, NY : IEEE, US, 3 June 1998 (1998-06-03), pages 33 - 36, XP000801030, ISBN: 978-0-7803-4752-6, DOI: 10.1109/ISPSD.1998.702623

## Description

### TECHNICAL FIELD

The present disclosure relates to a field of semiconductor manufacturing, in particular to a diode, and further to a method for manufacturing a diode, and a semiconductor device.

### BACKGROUND

In the high-voltage SOI process, LIGBT (lateral insulated gate bipolar transistor) has become a dominant design in the market as a mainstream switching tube. For the switching process of LIGBT to drive inductive loads, a current in the inductance coil cannot change abruptly when the LIGBT is turned off, and at the same time, there is a trailing current when the LIGBT is turned off. The superposition of the two currents can easily lead to thermal breakdown of the LIGBT. Therefore, when the LIGBT is used as a switching device, a diode should be connected in parallel between a collector and an emitter of LIGBT to increase a current channel, so that redundant current can return to the coil to protect the LIGBT switching tube.

The forward conduction and reverse recovery characteristics of a freewheeling diode have a great impact on an entire switch module. The lower the forward conduction voltage, the lower the power consumption and heat generation. The reverse recovery of the freewheeling diode corresponds to turning on the LIGBT. If the reverse recovery time is long,

the diode has not recovered and the LIGBT has been turned on. The superposition of the two currents will also easily damage the switching tube. Therefore, reducing the reverse recovery time of the freewheeling diode and reducing the recovery peak current in a corresponding direction has always been a difficulty in the industry.

US 2012/032313 A1 relates to a semiconductor device featuring a lateral SOI diode with improved reverse recovery and avalanche capabilities. It addresses limitations of prior designs, such as poor avalanche performance during high-speed switching. In an embodiment, a cathode trench contact is provided within the cathode doped region. The device integrates a semiconductor substrate with regions of varying impurity concentrations, enabling optimized electrical performance. Key innovations include the inclusion of ohmic and Schottky contacts to enhance reverse recovery while maintaining current flow and reducing avalanche breakdown risks.

AKIO NAKAGAWA ET AL: "BREAKDOWN VOLTAGE ENHANCEMENT FOR DEVICES ON THIN SILICON LAYER/SILICON DIOXIDE FILM" discusses advancements in high-voltage semiconductor devices using a thin silicon layer over silicon dioxide (SOI) substrates. It introduces methods to enhance breakdown voltage by optimizing the distribution of electric fields, particularly using shallow n-type diffusion layers and interface charges. The proposed structure leverages trench isolation and dielectric techniques to achieve high breakdown voltages exceeding 500V while minimizing leakage currents and parasitic effects. The innovations enable reliable, high-density integration of power devices and logic circuits on a single chip. These advancements promise low-cost, efficient solutions for high-voltage power integrated circuits (ICs).

FUNAKI H ET AL: "LATERAL SOI DIODE DESIGN OPTIMIZATION FOR HIGH RUGGEDNESS AND LOW TEMPERATURE DEPENDENCE OF REVERSE RECOVERY CHARACTERISTICS" explores the optimization of lateral SOI diode designs for high ruggedness and low temperature dependence in reverse recovery characteristics. It compares three diode structures-n*/p*, p-/p*, and shallow p/p*-and finds the p-/p* structure offers the best balance of performance and durability, particularly at high temperatures. The study demonstrates that reducing SOI layer thickness enhances switching speed, while optimizing emitter injection efficiency minimizes parasitic effects. Experimental results highlight the p-/p* diode's superior capability for high-current turn-off and its effectiveness in inverter circuit applications at temperatures up to 200°C. These advancements support the development of cost-efficient, high-performance power ICs with integrated high-speed diodes.

US 2005/056906 A1 describes a semiconductor device with a high breakdown voltage structure for improved reliability and integration. It features a RESURF (reduced surface field) structure for voltage termination, a power element, and a driving unit integrated within an insulation region. A level shift element spans both sides of the junction, connecting the driving unit without traversing ground-level regions, reducing parasitic element operation and simplifying insulation requirements. The device supports integration of IGBTs, FWDs, and MOSFETs, enabling low-cost, high-voltage (over 1000V) one-chip inverters with enhanced reliability. Logic elements and additional insulation regions further enhance performance and inhibit parasitic effects.

US 2017/025411 A1 relates to a semiconductor device, specifically a fast recovery diode with improved performance. Fast recovery diodes typically balance forward current and reduced reverse recovery time (tRR), but higher voltage endurance increases tRR, creating a need for advanced designs. The proposed device uses a silicon-on-insulator (SOI) substrate to enhance reliability by suppressing parasitic effects such as latch-up and leakage currents. Its lateral design, inspired by field-effect transistor (FET) concepts, enables high forward current, shorter tRR, and compact device size. This innovation addresses limitations of conventional fast recovery diodes, achieving improved performance and high voltage endurance.

### SUMMARY

Accordingly, it is necessary to provide a diode with a short reverse recovery time, a method for manufacturing the diode, and a semiconductor device.

The above objective is achieved by means of a diode according to claim 1 and of a method for manufacturing a diode according to claim 12. Advantageous embodiments of the invention are set out in the dependent claims.

Details of one or more embodiments of the present disclosure are set forth in the following drawings and descriptions. Other features, objects and advantages of the present disclosure become apparent from the description, drawings and claims.

### BRIEF DESCRIPTION OF THE DRAWINGS

In order to better describe and illustrate embodiments and/or examples of those present disclosures disclosed herein, reference may be made to one or more figures. Additional details or examples used to describe the drawings should not be considered as limiting the scope of any of the disclosed present disclosures, the currently described embodiments and/or examples, and the best mode of these present disclosures currently understood.
FIG. 1 is a schematic cross-sectional view of a diode according to an embodiment.
FIG. 2 is a schematic cross-sectional view of the diode according to another embodiment.
FIG. 3 is a flowchart of a method for manufacturing a diode according to an embodiment.
FIGS. 4a to 4e are schematic cross-sectional views of a device in a process of manufacturing the diode using the method shown in FIG. 3.
FIG. 5 is a schematic cross-sectional view of a diode of a comparative example.

### DETAILED DESCRIPTION OF THE EMBODIMENTS

In order to facilitate the understanding of the present disclosure, the present disclosure will be described more fully below with reference to relevant attached drawings. Preferred embodiments of the present disclosure are illustrated in the drawings. However, the present disclosure can be implemented in many different forms and is not limited to the embodiments described herein. On the contrary, providing these embodiments is to assist understanding the content disclosed by the present disclosure more fully and thoroughly.

Unless otherwise defined, all technical and scientific terms used herein have the same meaning as commonly understood by those skilled in the technical field of the present disclosure. The terms used in the specification of the present disclosure herein are only for the purpose of describing specific embodiments, and are not intended to limit the present disclosure. The term "and/or" as used herein includes any and all combinations of one or more related listed items.

It will be understood that when an element or layer is referred to as being "on", "adjacent", "connected to" or "coupled to" another element or layer, it can be directly on, adjacent to, connected to, or coupled to the other element or layer, or intervening elements or layers may be present. In contrast, when an element is referred to as being "directly on", "directly adj acent to", "directly connected to", or "directly coupled to" another element or layer, no intervening elements or layers are present. It will be understood that, although the terms first, second, third etc. may be used to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present disclosure.

The spatial relationship terms such as "under", "below", "on", "above", etc., may be used herein for convenience of description to describe the relationship of one element or feature to other elements or features shown in the figures. It will be understood that the spatial relationship terms are intended to encompass different orientations of the device in use and operation in addition to the orientation shown in the figures. For example, if a device in the figures is turned over, elements or features described as "below" or "under" other elements or features would then be oriented "above" the other elements or features. Thus, the exemplary terms "below" and "under" may encompass both upper and lower orientations. The device may be in alternative orientations (rotated 90 degrees or at other orientations) and the spatial descriptors used herein interpreted accordingly.

The terms used herein is for the purpose of describing particular embodiments only and is not intended to be limiting of the present disclosure. As used herein, the singular forms "a", "an" and "the" are intended to include the plural forms as well, unless the context clearly dictates otherwise. It should also be understood that the terms "consists of" and/or "including", when used in this specification, specify the presence of stated features, integers, steps, operations, elements and/or components, but do not preclude the presence or addition of one or more other features, integers, steps, operations, elements, components, and/or groups thereof. As used herein, the term "and/or" includes any and all combinations of the associated listed items.

Embodiments of the present disclosure are described herein with reference to cross-section views of desirable embodiments (and intermediate structures) of the present disclosure. As such, variations from the shapes shown due to, for example, manufacturing techniques and/or tolerances may be expected. Accordingly, embodiments of the present disclosure should not be limited to the particular shapes of regions illustrated herein, but rather include deviations in shape due to, for example, manufacturing. For example, an implanted region illustrated as a rectangle will, typically, have rounded or curved features and/or a gradient of implant concentration at its edges rather than a binary change from implanted to non-implanted region. Similarly, a buried region formed by implantation may result in some implantation in the region between the buried region and the surface through which the implantation was performed. Thus, the regions shown in the figures are schematic in nature, and their shapes are not intended to illustrate the actual shape of the region of a device and are not intended to limit the scope of the present disclosure.

Terms related to a semiconductor field used herein are technical terms commonly used by those skilled in the art. For example, for P type and N type impurities, in order to distinguish a doping concentration, a P+ type simply represents a P type with heavy doping concentration, a P type represents a P type with medium doping concentration, a P- type represents a P type with light doping concentration, a N+ type represents a N type with heavy doping concentration, a N type represents a N type with medium doping concentration, and a N- type represents a N type with light doping concentration.

In conventional high-voltage diodes, when the diode is conducted forward, a large number of minority carrier holes will be injected, which will generate current and carry out freewheeling. When the freewheeling phase is over, these holes remain in the device (diode). In addition, in order to achieve high withstand voltage, the high-voltage diode has a long drift region, and there are many intrinsic minority carriers stored in the drift region of the diode. Therefore, when the high-voltage diode is turned from forward conduction to reverse cut-off, the minority carriers cannot be recombined quickly. The reverse recovery time becomes very long, and the corresponding peak current during reverse recovery is also very large, so that it is difficult to meet the high speed and low loss switching requirements in a switching device.

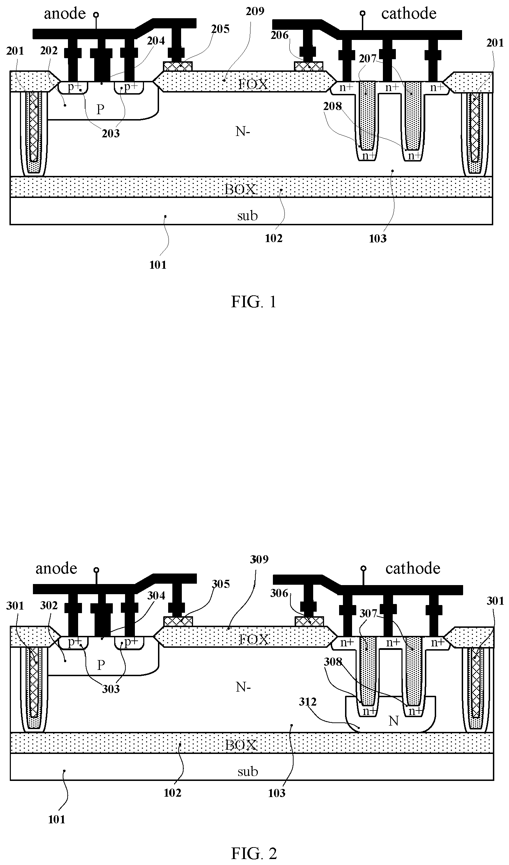

FIG. 1 is a schematic cross-sectional view of a diode according to an embodiment. In this embodiment, the diode is integrated with a lateral insulated gate bipolar transistor of SOI (silicon on insulator) structure for manufacturing and using, so that the diode is also based on the SOI structure. As shown in FIG. 1, the diode includes a substrate 101, an insulating buried layer 102, a semiconductor layer 103, an anode, and a cathode. The cathode includes a trench type contact 207, a cathode doped region 208, and a cathode electrode.

The trench type contact 207 is a structure in which a contact material is filled in a trench. In an embodiment of the present disclosure, the contact material may be silicon oxide (e.g., silicon dioxide), polysilicon, amorphous silicon (a-Si), or some dielectric material with good fluidity.

The cathode doped region 208 has a first conductivity type. The cathode doped region 208 is provided at a periphery and a bottom of the trench type contact 207 and surrounds the trench type contact 207. The cathode doped region 208 is also provided around the trench type contact 207 on a surface of the semiconductor layer 103. In the embodiment shown in FIG. 1, the first conductivity type is N type, and a second conductivity type is P type.

The cathode electrode is provided on the cathode doped region 208 and is electrically connected to the cathode doped region 208.

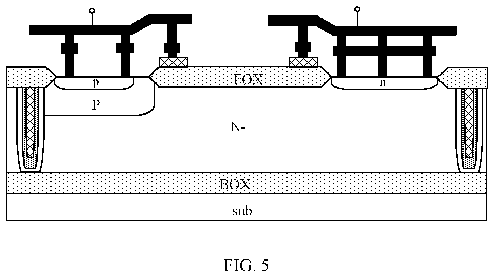

In the above diode, the cathode is provided with the trench type contact 207, and the cathode doped region 208 is formed at the periphery and the bottom of the trench, so that the cathode doped region 208 includes a lateral region on a surface of the semiconductor layer 103, a longitudinal region along a trench wall, and a trench bottom region. An area of the cathode doped region 208 is greatly increased compared with a cathode doped region of a comparative example shown in FIG. 5, so that when the parallel lateral insulated gate bipolar transistor is turned off, an area of the diode configured to collect and recombine minority carriers is increased, and a speed and efficiency of the diode reverse recovery are high.

The semiconductor layer 103 includes a drift region of the first conductivity type. In the embodiment shown in FIG. 1, the drift region is an N- region, the cathode doped region 208 is an N+ region.

In the embodiment shown in FIG. 1, the diode further includes a field oxide (FOX) structure 209 and a cathode polysilicon field plate 206. The field oxide structure 209 is provided on the semiconductor layer 103 and is located between the anode and the cathode of the diode. The cathode polysilicon field plate 206 is provided on the field oxide structure 209 and electrically connected to the cathode electrode. Specifically, the cathode electrode can be electrically connected to the cathode polysilicon field plate 206 through a contact. Since the cathode polysilicon field plate 206 is provided on the field oxide structure 209, electric field lines in the cathode region can be adjusted during reverse depletion of the diode.

The diode includes at least one trench type contact 207. Since a width of the trench is small (the width of each trench type contact 207 is 0.3% to 0.5% of a width of the cathode), adding the trench type contact 207 has little effect on the overall area of the device. Compared with a method of increasing the recombination rate by increasing the area of the cathode doped region 208 on the surface of the semiconductor layer 103, the area of the device is smaller. Moreover, increasing the area of the cathode doped region 208 on the surface of the semiconductor layer 103 will result in an increase in an area of the drift region, and the inherent minority carriers in the diode will also increase with the increase in the area of the drift region, which is not conducive to the efficiency of reverse recombination.

In an embodiment of the present disclosure, the cathode electrode forms an ohmic contact with the cathode doped region 208 through a contact, and the cathode electrode is not in direct contact with the trench type contact 207. Specifically, the cathode electrode may be connected to a lateral region of the cathode doped region 208 located on the surface of the semiconductor layer 103 through the contact.

In the embodiment shown in FIG. 1, the anode includes a well region 202, an anode doped region 203, and an anode electrode. The well region 202 has the second conductivity type and is provided in the semiconductor layer 103. The anode doped region 203 is of the second conductivity type and is provided in the well region 202. A doping concentration of the anode doped region 203 is greater than that of the well region 202. In the embodiment shown in FIG. 1, the well region 202 is a high voltage P well, and the anode doped region 203 is a P+ region. A part of the anode electrode is in direct contact with the anode doped region 203 through a contact, and another part of the anode electrode is in direct contact with the well region 202 through a contact. It should be understood that the contact in contact with the anode doped region 203 and the contact in contact with the well region 202 are different contacts.

In the embodiment shown in FIG. 1, the well region 202 includes at least two anode doped regions 203, and the anode doped regions 203 in the well region 202 are spaced apart from each other by the well region 202. Each anode doped region 203 forms an ohmic contact with a conductive material in the corresponding contact, and the well region 202 forms a Schottky contact 204 with the conductive material in the corresponding contact. A part of the well region 202 located between the anode doped regions 203 forms a Schottky contact by directly contacting the corresponding contact, which can reduce the efficiency of minority carrier injection when the diode is conducted forward, and a conductance modulation effect can be formed. In combination with the cathode trench N+ ohmic contact structure of the present disclosure, the number of minority carriers can be further reduced, and the reverse recovery time can be shortened.

In the embodiment shown in FIG. 1, the diode further includes an anode polysilicon field plate 205 provided on the field oxide structure 209. The anode polysilicon field plate 205 is electrically connected to the anode. Since the anode polysilicon field plate 205 is provided on the field oxide structure 209, electric field lines in the anode region can be adjusted during reverse depletion of the diode.

In the embodiment shown in FIG. 1, an isolation trench structure 201 is further provided on an outside of the well region 202 (i.e., a side away from the cathode), and an isolation trench structure 201 is also provided on an outside of the cathode doped region 208 (i.e., a side away from the anode). The isolation trench structure 201 extends downwards to the insulating buried layer 102, so as to be an isolation structure for the diode on the SOI material. In the embodiment shown in FIG. 1, the field oxide structures (not labeled in FIG. 1) are further provided on both isolation trench structures 201. In an embodiment of the present disclosure, the isolation trench structure 201 is filled with a dielectric layer, which may be, for example, a silicon oxide material, or may be formed by forming silicon dioxide on the sidewall of the trench, and then the remaining positions are filled with polysilicon and planarized.

In an embodiment of the present disclosure, the diode is a fast recovery SOI high voltage freewheeling diode.

In an embodiment of the present disclosure, both the substrate 101 and the semiconductor layer 103 are silicon layers. The insulating buried layer 102 is a buried oxide layer, and the material of the insulating buried layer 102 may be silicon dioxide.

FIG. 2 is a schematic cross-sectional view of the diode according to another embodiment. In this embodiment, the diode includes the substrate 101, the insulating buried layer 102, and the semiconductor layer 103 that are stacked sequentially. A well region 302, a trench type contact 307, and a cathode doped region 308 are provided in the semiconductor layer 103. A plurality of anode doped regions 303 are provided in the well region 302. The cathode electrode forms an ohmic contact with the cathode doped region 308 through the contact, the anode electrode forms an ohmic contact with each anode doped region 303 through the corresponding contact, and forms a Schottky contact 304 with the well region 302 through the corresponding contact. In the semiconductor layer 103, two isolation trench structures 301 are provided on both sides of the diode, the field oxide structure is provided on the isolation trench structure 301, and a field oxide structure 309 is also provided on the surface of the semiconductor layer 103 between the well region 302 and the cathode doped region 308. An anode polysilicon field plate 305 and a cathode polysilicon field plate 306 are provided on an anode side and a cathode side of the field oxide structure 309, respectively. The anode polysilicon field plate 305 is electrically connected to the anode electrode through the contact, and the cathode polysilicon field plate 306 is electrically connected to the cathode electrode through the contact.

The main difference between the embodiments shown in FIG. 2 and FIG. 1 lies in that the diode further includes a first conductivity type well region 312. The first conductivity type well region 312 is provided at a bottom of the trench type contact 307 and extends downwards to the insulating buried layer 102. In the embodiment shown in FIG. 2, the first conductivity type well region 312 is an N well, and the doping concentration of the first conductivity type well region 312 is greater than the doping concentration of the N-drift region of the semiconductor layer 103 and less than the doping concentration of the cathode doped region 308. The first conductivity type well region 312 with a doping concentration higher than that of the drift region is provided at the bottom of the trench, so that the resistivity of the region adj acent to the bottom of the trench can be reduced, and more minority carriers can be absorbed to participate in the recombination during the reverse recovery of the diode, thereby further improving the recombination efficiency of the minority carriers during the reverse recovery of the diode.

The present disclosure correspondingly provides a semiconductor device based on an SOI structure, which includes the lateral insulated gate bipolar transistor (LIGBT) and the diode as described in any of the aforementioned embodiments. The LIGBT and the diode are both integrated on the SOI structure, and the diode is connected in parallel between a collector and an emitter of LIGBT.

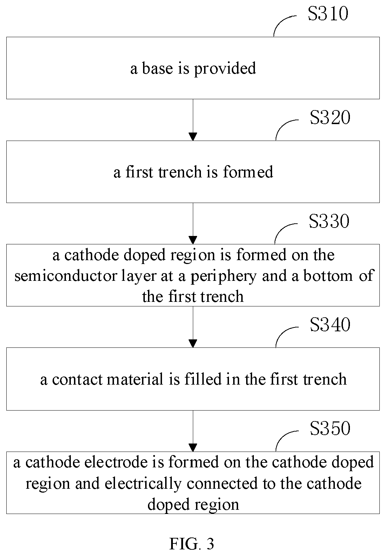

FIG. 3 is a flowchart of a method for manufacturing a diode according to an embodiment, which includes the following steps.

In S310, a base is provided.

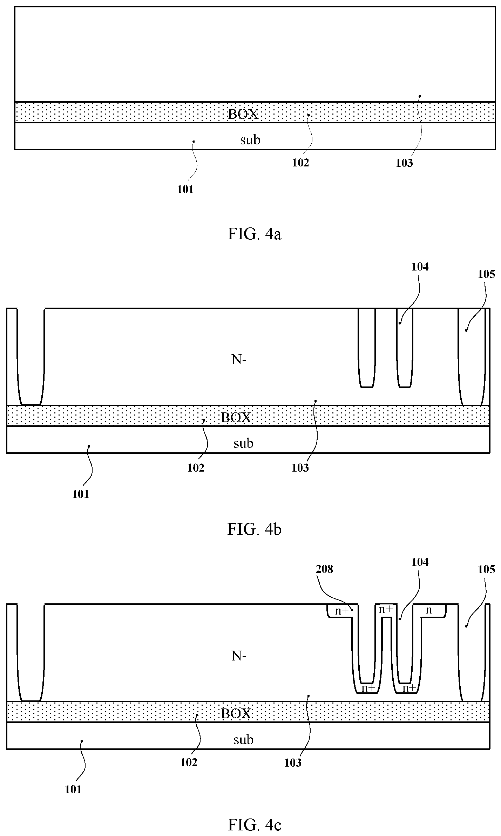

Referring to FIG. 4a, the base includes a substrate 101, an insulating buried layer 102, and a semiconductor layer 103 that are sequentially stacked. In an embodiment of the present disclosure, both the substrate 101 and the semiconductor layer 103 are silicon layers. The insulating buried layer 102 is a buried oxide layer, and the material of the insulating buried layer 102 may be silicon dioxide. In an embodiment of the present disclosure, the semiconductor layer 103 includes a drift region of the first conductivity type. In the embodiment shown in FIG. 4a, the first conductivity type is N type, the second conductivity type is P type, and the drift region is N-drift region.

S320, a first trench is formed.

In an embodiment of the present disclosure, at least one first trench 104 is formed by etching downward from the surface of the semiconductor layer 103 through photolithography and etching processes.

In the embodiment shown in FIG. 4b, while the first trench 104 is etched, the isolation trench 105 configured to isolate the diodes is etched simultaneously. A width of the first trench 104 is provided smaller through photolithography, so that an etching rate of the first trench 104 is slower. A width of the isolation trench 105 is greater than the width of the first groove 104, and the etching rate is faster, so that when a bottom of the isolation trench 105 is etched to the insulating buried layer 102, a bottom of the first trench 104 is still a distance away from the insulating buried layer 102. In an embodiment of the present disclosure, the width of each first trench 104 is 0.3% to 0.5% of the width of the cathode region of the diode. By controlling the width of the first trench 104 and a depth-to-width ratio of etching in the process, the first trench 104 and the isolation trench 105 can be formed at the same time (in the same process), so that the manufacturing cost can be saved and the manufacturing efficiency can be improved.

S330, a cathode doped region is formed on the semiconductor layer at a periphery and a bottom of the first trench.

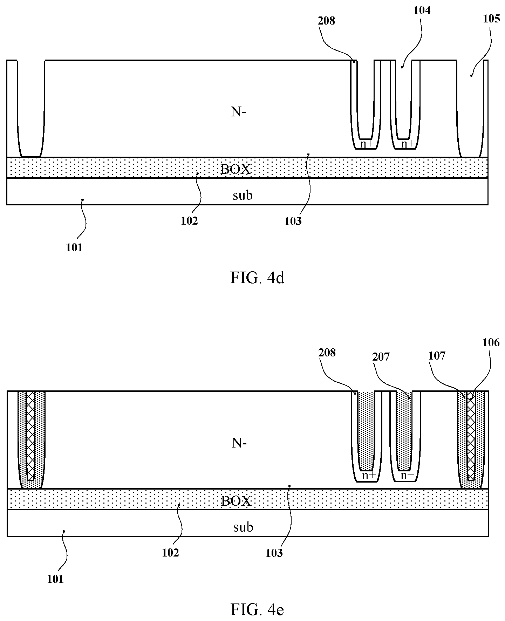

In an embodiment of the present disclosure, the cathode doped region 208 is formed by implanting ions of the first conductivity type through an ion implantation process, as shown in FIG. 4c. In the embodiment shown in FIG. 4c, the cathode doped region 208 is an N+ region. In other embodiments, as shown in FIG. 4d, the implantation of N type ions in step S330 may also form the cathode doped region 208 on the sidewall and bottom of the first trench 104 first, and then form the cathode doped region 208 on the surface of the semiconductor layer 103 through another ion implantation process.

S340, a contact material is filled in the first trench.

In an embodiment of the present disclosure, step S340 includes a step of oxidizing the sidewall of the trench. As for the first trench 104, since the width of the first trench 104 is relatively small, the first trench 104 can be filled only through the step of oxidizing the sidewall of the trench, while the width of the isolation trench 105 is larger, therefore after the sidewall of the trench is oxidized, the remaining position of the isolation trench 105 can be filled with a dielectric or polysilicon and then planarized, as shown in FIG. 4e.

S350, a cathode electrode is formed on the cathode doped region and electrically connected to the cathode doped region.

The remaining structure of the cathode and the anode of the diode may be formed after step S340, which includes forming the field oxide structure, forming the well region in the semiconductor layer 103, forming the anode doped region in the well region, forming the anode polysilicon field plate and the cathode polysilicon field plate on the field oxide structure, and forming the anode electrode and the cathode electrode. The anode electrode is electrically connected to the anode polysilicon field plate, the well region and the anode doped region through the contact, forms the ohmic contact with the anode doped region and forms the Schottky contact with the well region. The cathode electrode is electrically connected to the cathode polysilicon field plate and the cathode doped region through the contact, and forms the ohmic contact with the cathode doped region.

It should be understood that although the various steps in the flow charts of the present application are shown sequentially as indicated by the arrows, the steps need not necessarily be performed sequentially in the order indicated by the arrows. Unless otherwise specified herein, there is no strict order of execution of the steps, and the steps may be executed in other orders. Moreover, at least some of the steps in the flow chart of the present disclosure may include multiple steps or multiple stages. These steps or stages are not necessarily performed at the same time, but may be performed at different times. The execution order of these steps or stages is not necessarily sequential, but may be performed in turn or alternately with other steps or at least a part of the steps or stages in other steps.

In the description of this specification, the descriptions referring to the terms "some embodiments", "other embodiments", "ideal embodiments" and the like mean that specific features, structures, materials, or characteristics described in connection with the embodiments or examples are included in at least one embodiment or example of the present disclosure. In this specification, schematic descriptions of the above terms do not necessarily refer to the same embodiment or example.

The scope of the present invention is defined exclusively by the appended claims.

## Claims

1. A diode based on a silicon on insulator structure, comprising:
a substrate (101);
an insulating buried layer (102) provided on the substrate (101);
a semiconductor layer (103) having a first conductivity type provided on the insulating buried layer (102);
an anode; and
a cathode comprising:
a trench type contact (207) consisting of a trench being filled with a material, the trench extending from a first surface of the semiconductor layer (103) towards a second surface of the semiconductor layer (103), the first surface being a surface away from the insulating buried layer (102), and the second surface being a surface facing the insulating buried layer (102);
a cathode doped region (208) having the first conductivity type, the cathode doped region (208) being provided at a periphery and a bottom of the trench type contact (207) and surrounding the trench type contact (207), and the cathode doped region (208) being provided on the first surface around the trench type contact (207); and
a cathode electrode provided on the cathode doped region (208) and electrically connected to the cathode doped region (208),
wherein the bottom of the trench is closer to the second surface than a bottom surface of the portion of the cathode doped region (208) provided on the first surface around the trench type contact (207).

2. The diode according to claim 1, wherein the material comprises at least one selected from the group consisting of silicon oxide, polysilicon, and amorphous silicon.

3. The diode according to claim 1, further comprising:
a field oxide structure (209) provided on the semiconductor layer (103) and located between the anode and cathode; and
a cathode polysilicon field plate (206) provided on the field oxide structure (209) and electrically connected to the cathode electrode.

4. The diode according to claim 1, wherein at least one trench type contact (207) is provided, and a width of each trench type contact (207) is 0.3% to 0.5% of a width of the cathode.

5. The diode according to claim 1, wherein the cathode electrode is in electrical contact with the cathode doped region (208) through a contact, and an ohmic contact is formed between the conductive material in the contact and the cathode doped region (208).

6. The diode according to claim 1, wherein the anode comprises:
a well region (202) having a second conductivity type and provided in the semiconductor layer (103);
an anode doped region (203) having the second conductivity type and provided in the well region (202), a doping concentration of the anode doped region (203) being greater than a doping concentration of the well region (202); and
an anode electrode, a part of the anode electrode being in contact with the anode doped region (203) through a contact, and a part of the anode electrode being in contact with the well region (202) through a contact.

7. The diode according to claim 6, wherein the well region (202) comprises at least two anode doped regions (203), the anode doped regions (203) in the well region (202) are spaced apart from each other through the well region (202), each anode doped region (203) forms an ohmic contact with a conductive material in the contact, and the well region (202) forms a Schottky contact with the conductive material in the contact.

8. The diode according to claim 6, further comprising an anode polysilicon field plate (205) provided on the field oxide structure (209) and electrically connected to the anode electrode.

9. The diode according to claim 1, further comprising a first conductivity type well region provided (312) at the bottom of the trench type contact (207) and extending towards the insulating buried layer (102), the semiconductor layer (103) comprising a drift region of the first conductivity type, a doping concentration of the first conductivity type well region (312) being greater than a doping concentration of the drift region.

10. The diode according to claim 6, further comprising a plurality of isolation trench structures (201) extending downwards to the insulating buried layer (102), the isolation trench structures (201) being provided on a side of the well region (202) away from the cathode and a side of the cathode doped region (208) away from the anode.

11. A semiconductor device based on a silicon on insulator structure, comprising:
a lateral insulated gate bipolar transistor; and
the diode according to claim 1 integrated with the lateral insulated gate bipolar transistor, the diode being connected in parallel between a collector and an emitter of the lateral insulated gate bipolar transistor.

12. A method for manufacturing a diode, the diode being based on a silicon on insulator structure, the method comprising:
providing a base, the base comprising a substrate (101), an insulating buried layer (102), and a semiconductor layer (103) that are sequentially stacked, the semiconductor layer having a first conductivity type;
forming a first trench (104) extending from a first surface of the semiconductor layer (103) towards a second surface of the semiconductor layer (103), wherein the first surface is a surface away from the insulating buried layer (102), and the second surface is a surface facing the insulating buried layer (102);
forming a cathode doped region (208) on the semiconductor layer (103) at a periphery and a bottom of the first trench (104), the cathode doped region (208) having the first conductivity type;
filling a material in the first trench (104); and
forming a cathode electrode on the cathode doped region (208) and electrically connected to the cathode doped region (208);
wherein the bottom of the trench is closer to the second surface than a bottom surface of the portion of the cathode doped region (208) provided on the first surface around the trench type contact (207).

13. The method according to claim 12, wherein the step of forming the first trench (104) extending from the first surface of the semiconductor layer (103) towards the second surface of the semiconductor layer (103) is performed through an etching process, and an isolation trench structure (201) is simultaneously formed by etching, a width of the first trench (104) is less than a width of the isolation trench structure (201), the isolation trench structure (201) extends to the insulating buried layer (102), and a depth of the isolation trench structure (201) is greater than a depth of the first trench (104).

14. The method according to claim 12, wherein after the step of filling the material in the first trench (104), the method further comprises:
forming a field oxide structure (209).
forming a well region (202) in the semiconductor layer (103);
forming an anode doped region (203) in the well region (202);
forming an anode polysilicon field plate (205) and a cathode polysilicon field plate (206) on the field oxide structure (209); and
forming an anode electrode, the anode electrode being electrically connected to the anode polysilicon field plate (205), the well region (202), and the anode doped region (203).

## Patentansprüche

1. Diode, basierend auf einer Silicium-auf-Isolator-Struktur, die Folgendes umfasst:
ein Substrat (101);
eine isolierende vergrabene Schicht (102), die auf dem Substrat (101) bereitgestellt ist;
eine Halbleiterschicht (103) mit einem ersten Leitfähigkeitstyp, die auf der isolierenden vergrabenen Schicht (102) bereitgestellt ist;
eine Anode; und
eine Kathode, die Folgendes umfasst:
einen Grabentypkontakt (207), der aus einem Graben besteht, der mit einem Material gefüllt ist, wobei sich der Graben von einer ersten Oberfläche der Halbleiterschicht (103) zu einer zweiten Oberfläche der Halbleiterschicht (103) erstreckt, wobei die erste Oberfläche eine von der isolierenden vergrabenen Schicht (102) abgewandte Oberfläche ist und die zweite Oberfläche eine der isolierenden vergrabenen Schicht (102) zugewandte Oberfläche ist;
ein Kathodendotierungsgebiet (208) mit dem ersten Leitfähigkeitstyp, wobei das Kathodendotierungsgebiet (208) an einer Peripherie und einer Unterseite des Grabentypkontakts (207) bereitgestellt ist und den Grabentypkontakt (207) umgibt, und wobei das Kathodendotierungsgebiet (208) auf der ersten Oberfläche um den Grabentypkontakt (207) herum bereitgestellt ist; und
eine Kathodenelektrode, die auf dem Kathodendotierungsgebiet (208) bereitgestellt ist und elektrisch mit dem Kathodendotierungsgebiet (208) verbunden ist,
wobei die Unterseite des Grabens näher an der zweiten Oberfläche ist als eine untere Oberfläche des Teils des Kathodendotierungsgebiets (208), der auf der ersten Oberfläche um den Grabentypkontakt (207) herum bereitgestellt ist.

2. Diode nach Anspruch 1, wobei das Material mindestens eines umfasst, das aus der Gruppe ausgewählt ist, die aus Siliciumoxid, Polysilicium und amorphem Silicium besteht.

3. Diode nach Anspruch 1, die ferner Folgendes umfasst:
eine Feldoxidstruktur (209), die auf der Halbleiterschicht (103) bereitgestellt ist und sich zwischen der Anode und der Kathode befindet; und
eine Kathoden-Polysilicium-Feldplatte (206), die auf der Feldoxidstruktur (209) bereitgestellt und elektrisch mit der Kathodenelektrode verbunden ist.

4. Diode nach Anspruch 1, wobei mindestens ein Grabenkontakt (207) bereitgestellt ist und eine Breite jedes Grabenkontakts (207) 0,3 % bis 0,5 % einer Breite der Kathode beträgt.

5. Diode nach Anspruch 1, wobei sich die Kathodenelektrode durch einen Kontakt in elektrischem Kontakt mit dem Kathodendotierungsgebiet (208) befindet und ein ohmscher Kontakt zwischen dem leitfähigen Material in dem Kontakt und dem Kathodendotierungsgebiet (208) gebildet ist.

6. Diode nach Anspruch 1, wobei die Anode Folgendes umfasst:
ein Wannengebiet (202) mit einem zweiten Leitfähigkeitstyp, das in der Halbleiterschicht (103) bereitgestellt ist;
ein Anodendotierungsgebiet (203) mit dem zweiten Leitfähigkeitstyp und in dem Wannengebiet (202) bereitgestellt, wobei eine Dotierungskonzentration des Anodendotierungsgebiets (203) größer als eine Dotierungskonzentration des Wannengebiets (202) ist; und
eine Anodenelektrode, wobei ein Teil der Anodenelektrode über einen Kontakt mit dem Anodendotierungsgebiet (203) in Kontakt ist und ein Teil der Anodenelektrode über einen Kontakt mit dem Wannengebiet (202) in Kontakt ist.

7. Diode nach Anspruch 6, wobei das Wannengebiet (202) mindestens zwei Anodendotierungsgebiete (203) umfasst, die Anodendotierungsgebiete (203) in dem Wannengebiet (202) durch das Wannengebiet (202) voneinander beabstandet sind, jedes Anodendotierungsgebiet (203) einen ohmschen Kontakt mit einem leitfähigen Material in dem Kontakt bildet und das Wannengebiet (202) einen Schottky-Kontakt mit dem leitfähigen Material in dem Kontakt bildet.

8. Diode nach Anspruch 6, die ferner eine Anoden-Polysilicium-Feldplatte (205) umfasst, die auf der Feldoxidstruktur (209) bereitgestellt und elektrisch mit der Anodenelektrode verbunden ist.

9. Diode nach Anspruch 1, die ferner ein Wannengebiet vom ersten Leitfähigkeitstyp umfasst, das an der Unterseite des Grabentypkontakts (207) bereitgestellt ist (312) und sich zu der isolierenden vergrabenen Schicht (102) erstreckt, wobei die Halbleiterschicht (103) ein Driftgebiet vom ersten Leitfähigkeitstyp umfasst, wobei eine Dotierungskonzentration des Wannengebiets vom ersten Leitfähigkeitstyp (312) größer als eine Dotierungskonzentration des Driftgebiets ist.

10. Diode nach Anspruch 6, die ferner mehrere Isolationsgrabenstrukturen (201) umfasst, die sich nach unten zu der isolierenden vergrabenen Schicht (102) erstrecken, wobei die Isolationsgrabenstrukturen (201) auf einer von der Kathode abgewandten Seite des Wannengebiets (202) und einer von der Anode abgewandten Seite des Kathodendotierungsgebiets (208) bereitgestellt sind.

11. Halbleitervorrichtung basierend auf einer Silicium-auf-Isolator-Struktur, die Folgendes umfasst:
einen lateralen Bipolartransistor mit isoliertem Gate; und
Diode nach Anspruch 1, die in den lateralen Bipolartransistor mit isoliertem Gate integriert ist, wobei die Diode zwischen einem Kollektor und einem Emitter des lateralen Bipolartransistors mit isoliertem Gate parallel geschaltet ist.

12. Verfahren zum Herstellen einer Diode, wobei die Diode auf einer Silicium-auf-Isolator-Struktur basiert, wobei das Verfahren Folgendes umfasst:
Bereitstellen einer Basis, wobei die Basis ein Substrat (101), eine isolierende vergrabene Schicht (102) und eine Halbleiterschicht (103) umfasst, die sequentiell gestapelt sind, wobei die Halbleiterschicht einen ersten Leitfähigkeitstyp aufweist;
Bilden eines ersten Grabens (104), der sich von einer ersten Oberfläche der Halbleiterschicht (103) zu einer zweiten Oberfläche der Halbleiterschicht (103) erstreckt, wobei die erste Oberfläche eine von der isolierenden vergrabenen Schicht (102) abgewandte Oberfläche ist und die zweite Oberfläche eine der isolierenden vergrabenen Schicht (102) zugewandte Oberfläche ist;
Bilden eines Kathodendotierungsgebiets (208) auf der Halbleiterschicht (103) an einer Peripherie und einer Unterseite des ersten Grabens (104), wobei das Kathodendotierungsgebiet (208) den ersten Leitfähigkeitstyp aufweist;
Füllen eines Materials in den ersten Graben (104); und
Bilden einer Kathodenelektrode auf dem Kathodendotierungsgebiet (208) und elektrisch mit dem Kathodendotierungsgebiet (208) verbunden;
wobei die Unterseite des Grabens näher an der zweiten Oberfläche ist als eine untere Oberfläche des Teils des Kathodendotierungsgebiets (208), der auf der ersten Oberfläche um den Grabentypkontakt (207) herum bereitgestellt ist.

13. Verfahren nach Anspruch 12, wobei der Schritt zum Bilden des ersten Grabens (104), der sich von der ersten Oberfläche der Halbleiterschicht (103) zu der zweiten Oberfläche der Halbleiterschicht (103) erstreckt, durch einen Ätzprozess durchgeführt wird, und gleichzeitig eine Isolationsgrabenstruktur (201) durch Ätzen gebildet wird, wobei eine Breite des ersten Grabens (104) kleiner als eine Breite der Isolationsgrabenstruktur (201) ist, sich die Isolationsgrabenstruktur (201) zu der isolierenden vergrabenen Schicht (102) erstreckt und eine Tiefe der Isolationsgrabenstruktur (201) größer als eine Tiefe des ersten Grabens (104) ist.

14. Verfahren nach Anspruch 12, wobei das Verfahren nach dem Schritt zum Füllen des Materials in den ersten Graben (104) ferner Folgendes umfasst:
Bilden einer Feldoxidstruktur (209).
Bilden eines Wannengebiets (202) in der Halbleiterschicht (103);
Bilden eines Anodendotierungsgebiets (203) in dem Wannengebiet (202);
Bilden einer Anoden-Polysilicium-Feldplatte (205) und einer Kathoden-Polysilicium-Feldplatte (206) auf der Feldoxidstruktur (209); und
Bilden einer Anodenelektrode, wobei die Anodenelektrode elektrisch mit der Anoden-Polysilicium-Feldplatte (205), dem Wannengebiet (202) und dem Anodendotierungsgebiet (203) verbunden ist.

## Revendications

1. Diode à base d'une structure de type silicium sur isolant, comprenant :
un substrat (101) ;
une couche enterrée isolante (102) prévue sur le substrat (101) ;
une couche semi-conductrice (103) présentant un premier type de conductivité, prévue sur la couche enterrée isolante (102) ;
une anode ; et
une cathode comprenant :
un contact de type tranchée (207) constitué d'une tranchée qui est remplie d'un matériau, la tranchée s'étendant d'une première surface de la couche semi-conductrice (103) à une seconde surface de la couche semi-conductrice (103), la première surface étant une surface éloignée de la couche enterrée isolante (102), et la seconde surface étant une surface faisant face à la couche enterrée isolante (102) ;
une région dopée de cathode (208) présentant le premier type de conductivité, la région dopée de cathode (208) étant prévue au niveau d'une périphérie et d'un fond du contact de type tranchée (207) et entourant le contact de type tranchée (207), et la région dopée de cathode (208) étant prévue sur la première surface autour du contact de type tranchée (207) ; et
une électrode de cathode prévue sur la région dopée de cathode (208) et connectée électriquement à la région dopée de cathode (208),
dans laquelle le fond de la tranchée est plus près de la seconde surface qu'une surface inférieure de la partie de la région dopée de cathode (208) prévue sur la première surface autour du contact de type tranchée (207).

2. Diode selon la revendication 1, dans laquelle le matériau comprend au moins un matériau choisi dans le groupe constitué par l'oxyde de silicium, le polysilicium et le silicium amorphe.

3. Diode selon la revendication 1, comprenant en outre :
une structure d'oxyde de champ (209) prévue sur la couche semi-conductrice (103) et située entre l'anode et la cathode ; et
une plaque de champ cathodique en polysilicium (206) prévue sur la structure d'oxyde de champ (209) et connectée électriquement à l'électrode de cathode.

4. Diode selon la revendication 1, dans laquelle il est prévu au moins un contact de type tranchée (207), et une largeur de chaque contact de type tranchée (207) est de 0,3 % à 0,5 % de la largeur de la cathode.

5. Diode selon la revendication 1, dans laquelle l'électrode de cathode est en contact électrique avec la région dopée de cathode (208) par l'intermédiaire d'un contact, et un contact ohmique est formé entre le matériau conducteur dans le contact et la région dopée de cathode (208).

6. Diode selon la revendication 1, dans laquelle l'anode comprend :
une région de puits (202) présentant un second type de conductivité et prévue dans la couche semi-conductrice (103) ;
une région dopée d'anode (203) présentant le second type de conductivité et prévue dans la région de puits (202), une concentration de dopage de la région dopée d'anode (203) étant supérieure à une concentration de dopage de la région de puits (202) ; et
une électrode d'anode, une partie de l'électrode d'anode étant en contact avec la région dopée d'anode (203) par l'intermédiaire d'un contact, et une partie de l'électrode d'anode étant en contact avec la région de puits (202) par l'intermédiaire d'un contact.

7. Diode selon la revendication 6, dans laquelle la région de puits (202) comprend au moins deux régions dopées d'anode (203), les régions dopées d'anode (203) dans la région de puits (202) sont espacées l'une de l'autre par la région de puits (202), chaque région dopée d'anode (203) forme un contact ohmique avec un matériau conducteur dans le contact, et la région de puits (202) forme un contact Schottky avec le matériau conducteur dans le contact.

8. Diode selon la revendication 6, comprenant en outre une plaque de champ anodique en polysilicium (205) prévue sur la structure d'oxyde de champ (209) et connectée électriquement à l'électrode d'anode.

9. Diode selon la revendication 1, comprenant en outre une région de puits (312) du premier type de conductivité, prévue au fond du contact de type tranchée (207) et s'étendant vers la couche enterrée isolante (102), la couche semi-conductrice (103) comprenant une région de dérive du premier type de conductivité, une concentration de dopage de la région de puits (312) du premier type de conductivité étant supérieure à une concentration de dopage de la région de dérive.

10. Diode selon la revendication 6, comprenant en outre une pluralité de structures de tranchée d'isolation (201) s'étendant vers le bas jusqu'à la couche enterrée isolante (102), les structures de tranchée d'isolation (201) étant prévues sur un côté de la région de puits (202) qui est éloigné de la cathode et sur un côté de la région dopée de cathode (208) qui est éloigné de l'anode.

11. Dispositif à semi-conducteurs à base d'une structure de type silicium sur isolant, comprenant :
un transistor bipolaire à grille isolée latéral ; et
la diode selon la revendication 1 intégrée au transistor bipolaire à grille isolée latéral, la diode étant connectée en parallèle entre un collecteur et un émetteur du transistor bipolaire à grille isolée latéral.

12. Procédé de fabrication d'une diode, la diode étant à base d'une structure de type silicium sur isolant, le procédé comprenant :
la fourniture d'une base, la base comprenant un substrat (101), une couche enterrée isolante (102), et une couche semi-conductrice (103) empilées séquentiellement, la couche semi-conductrice présentant un premier type de conductivité ;
la formation d'une première tranchée (104) s'étendant d'une première surface de la couche semi-conductrice (103) à une seconde surface de la couche semi-conductrice (103), dans lequel la première surface est éloignée de la couche enterrée isolante (102), et la seconde surface est une surface faisant face à la couche enterrée isolante (102) ;
la formation d'une région dopée de cathode (208) sur la couche semi-conductrice (103) au niveau d'une périphérie et d'un fond de la première tranchée (104), la région dopée de cathode (208) présentant le premier type de conductivité ;
le remplissage de la première tranchée (104) avec un matériau ; et
la formation d'une électrode de cathode sur la région dopée de cathode (208) et connectée électriquement à la région dopée de cathode (208),
dans lequel le fond de la tranchée est plus près de la seconde surface qu'une surface inférieure de la partie de la région dopée de cathode (208) prévue sur la première surface autour du contact de type tranchée (207).

13. Procédé selon la revendication 12, dans lequel l'étape de formation de la première tranchée (104) s'étendant de la première surface de la couche semi-conductrice (103) à la seconde surface de la couche semi-conductrice (103) est effectuée au moyen d'un processus de gravure, et une structure de tranchée d'isolation (201) est formée simultanément par gravure, une largeur de la première tranchée (104) est inférieure à une largeur de la structure de tranchée d'isolation (201), la structure de tranchée d'isolation (201) s'étend jusqu'à la couche enterrée isolante (102), et une profondeur de la structure de tranchée d'isolation (201) est supérieure à une profondeur de la première tranchée (104).

14. Procédé selon la revendication 12, dans lequel, après l'étape de remplissage de la première tranchée (104) avec le matériau, le procédé comprend en outre :
la formation d'une structure d'oxyde de champ (209) ;
la formation d'une région de puits (202) dans la couche semi-conductrice (103) ;
la formation d'une région dopée d'anode (203) dans la région de puits (202) ;
la formation d'une plaque de champ anodique en polysilicium (205) et d'une plaque de champ cathodique en polysilicium (206) sur la structure d'oxyde de champ (209) ; et
la formation d'une électrode d'anode, l'électrode d'anode étant connectée électriquement à la plaque de champ anodique en polysilicium (205), à la région de puits (202) et à la région dopée d'anode (203).
